# EUROPÄISCHE PATENTSCHRIFT

(11) **EP 2 232 599 B1**
(45) Veröffentlichungstag und Bekanntmachung des Hinweises auf die Patenterteilung: **24.12.2014**
(21) Anmeldenummer: 09703799.8
(22) Anmeldetag: 22.01.2009
(51) Int. Cl.: H01L 41/083, H01L 41/047, H01L 41/273

(54) **PIEZOELEKTRISCHES VIELSCHICHTBAUELEMENT**
PIEZOELECTRIC MULTILAYER COMPONENT
COMPOSANT MULTICOUCHE PIÉZOÉLECTRIQUE

(30) Priorität: 23.01.2008 DE 102008005681
(43) Veröffentlichungstag der Anmeldung: 29.09.2010
(73) Patentinhaber: Epcos AG, 81669 München (DE)
(72) Erfinder: DERNOVSEK, Oliver, A-8501 Lieboch (AT); GLAZUNOV, Alexander, A-8530 Deutschlandsberg (AT)
(74) Vertreter: Epping - Hermann - Fischer
(86) Internationale Anmeldenummer: PCT/EP2009/000393
(87) Internationale Veröffentlichungsnummer: WO 2009/092583

(56) Entgegenhaltungen:
- WO-A-2006/135013
- WO-A-2007/102369
- DE-A1-102004 031 402

## Beschreibung

Es wird ein piezoelektrisches Vielschichtbauelement als Zwischenprodukt, ein Verfahren zur Herstellung eines piezoelektrischen Vielschichtbauelements sowie ein durch das Verfahren erzeugbares piezoelektrisches Vielschichtbauelement mit einem Bereich verringerter mechanischer Stabilität angegeben.

Aus DE 10 2006 031 085 A1 ist ein piezoelektrisches Vielschichtbauelement mit Sollbruchschichten bekannt. Aus WO 2007/102369 A ist ein piezoelektrisches Vielschichtbauelement, welches nach dem Sintern metallische Schichten mit Löchern enthält, bekannt.

Eine zu lösende Aufgabe besteht darin, ein piezoelektrisches Vielschichtbauelement anzugeben, welches über einen möglichst langen Zeitraum stabil betrieben werden kann.

Gemäß Anspruch 1 der Erfindung wird ein piezoelektrisches Vielschichtbauelement als Zwischenprodukt mit einem Stapel von übereinander angeordneten, grünen piezokeramischen Schichten angegeben, wobei eine erste Elektrodenschicht auf einer piezokeramischen Schicht aufgebracht ist und ein erstes Metall als Hauptkomponente mit einem Gewichtsanteil größer als 50 % enthält . Eine zweite Elektrodenschicht ist auf einer weiteren piezokeramischen Schicht aufgebracht und benachbart die erste Elektrodenschicht in Stapelrichtung. Die zweite Elektrodenschicht enthält das erste Metall in einer höheren Konzentration als die erste Elektrodenschicht. Der Begriff "Konzentration" bezeichnet dabei den Gewichtsanteil des Metalls in der jeweiligen Elektrodenschicht.

Wird das Zwischenprodukt gesintert, diffundiert das erste Metall aus der zweiten Elektrodenschicht teilweise zur ersten Elektrodenschicht und hinterlässt dabei Hohlräume in der zweiten Elektrodenschicht. Der Konzentrationsunterschied des ersten Metalls ist dabei so gewählt, dass die zweite Elektrodenschicht im Betrieb des Vielschichtbauelements noch als Elektrodenschicht dienen kann, bis das Vielschichtbauelement unter bestimmten mechanischen Belastungen in der zweiten Elektrodenschicht einreißt. Somit dient die zweite Elektrodenschicht auch als Sollbruchschicht.

Das erste Metall in der ersten Elektrodenschicht liegt in einer Konzentration von bis zu 80 % vor. Erfindungsgemäß besteht das erste Metall im Wesentlichen aus Kupfer, da es bei relativ niedrigen Temperaturen erweicht und somit ein schonendes Sintern des piezoelektrischen Vielschichtbauelements möglich ist, bei dem das Kupfer sich gut mit einer piezokeramischen Schicht bindet. Darüber hinaus hat sich herausgestellt, dass Kupfer, im Vergleich zu anderen Metallen, wie zum Beispiel Palladium oder Platin, verhältnismäßig leicht durch eine Piezokeramik diffundiert. Dies begünstigt die Herstellung eines nachfolgend beschriebenen piezoelektrischen Vielschichtbauelements mit einem Hohlräume aufweisenden, mechanischen geschwächten Bereich, der als Sollbruch-Elektrodenschicht dient.

Gemäß eines nicht erfindungsgemäßen Ausführungsbeispiels kann anstelle von Kupfer als erstes Metall ein anderes Metall verwendet werden, wie zum Beispiel Silber oder Nickel. Erfindungsgemäß enthält die erste Elektrodenschicht ein zusätzliches, zweites Metall, das sich vom ersten Metall unterscheidet.

Es wird bevorzugt, dass das zweite Metall schlechter durch eine der ersten Elektrodenschicht benachbarte piezokeramische Schicht diffundiert, als das erste Metall. Somit wird die Diffusion von Metall durch das Vielschichtbauelement überwiegend durch das erste Metall, insbesondere durch Kupfer, erreicht.

Das zweite Metall ist gewählt aus Mangan, Zinn, Wismut, Chrom, Molybdän, Niob, oder Rubidium. Das erste Metall liegt in der ersten Elektrodenschicht in einer höheren Konzentration vor als das zweite Metall. Beispielsweise können das erste Metall in einer Konzentration von 70 % und das zweite Metall in einer Konzentration von 30 % in der ersten Elektrodenschicht vorliegen. Wichtig dabei ist, dass die Konzentration des ersten Metalls in der ersten Elektrodenschicht niedriger ist als die Konzentration des ersten Metalls in der zweiten Elektrodenschicht, sodass eine Diffusion von der zweiten Elektrodenschicht zur ersten Elektrodenschicht stattfinden kann. Durch die Diffusion des ersten Metalls wird dessen Konzentrationsunterschied zwischen der ersten Elektrodenschicht und der zweiten Elektrodenschicht auf natürliche Weise verringert, d. h. die Konzentration des ersten Metalls in der zweiten Elektrodenschicht nimmt ab.

Gemäß einer Ausführungsform enthält die zweite Elektrodenschicht als Metall ausschließlich das erste Metall. Die zweite Elektrodenschicht kann also beispielsweise als Metall nur Kupfer enthalten. Sie kann jedoch auch eine Mischung von Kupfer (als erstes Metall) und beispielsweise Nickeloxid oder eine Legierung von Kupfer und Nickel enthalten.

Damit die Diffusion bevorzugt in einer Richtung stattfindet, sodass lediglich eine Sorte von Elektrodenschichten an einem Material verarmt und dadurch mechanisch abgeschwächt wird, werden Metalle in den ersten und in den zweiten Elektrodenschichten verwendet, die unterschiedliche Diffusionsraten im piezoelektrischen Keramikmaterial besitzen.

Vorzugsweise ist der Konzentrationsunterschied des ersten Metalls zwischen der ersten Elektrodenschicht und der zweiten Elektrodenschicht derart eingestellt, dass bei Erwärmung des Vielschichtbauelements eine Diffusion des ersten Metalls aus der zweiten Elektrodenschicht zu einem Materialverlust der zweiten Elektrodenschicht führt. Dabei ist der Konzentrationsunterschied, d. h. die Konzentration des ersten Metalls in der ersten Elektrodenschicht im Vergleich zur Konzentration des ersten Metalls in der zweiten Elektrodenschicht derart eingestellt, dass die zweite Elektrodenschicht nach Abwanderung eines Anteils des ersten Metalls strukturell intakt bleibt. So kann die zweite Elektrodenschicht im Betrieb des Vielschichtbauelements als Elektrodenschicht wirken.

Ein zu hoher Materialverlust der zweiten Elektrodenschicht würde dagegen dazu führen, dass sie zusammen mit einer piezokeramischen Schicht und einer gegenpoligen Elektrodenschicht kein nennenswertes elektrisches Feld mehr aufbauen kann, sodass damit auch keine Ausdehnung einer der zweiten Elektrodenschicht benachbarten Piezokeramik zustande kommen könnte. Die Leistung des piezoelektrischen Vielschichtbauelements im Betrieb würde somit abfallen.

Insbesondere wird der genannte Konzentrationsunterschied derart eingestellt, dass eine elektrische Verbindung zwischen der zweiten Elektrodenschicht und einem gegebenenfalls auf einer Seite des Stapels aufgebrachten Außenkontakt besteht bleibt. Die elektrische Verbindung zwischen einem Außenkontakt und einer zweiten Elektrodenschicht soll also aufgrund der Diffusion des ersten Metalls nicht unterbrochen werden.

Es wird bevorzugt, dass die piezokeramischen Schichten des piezoelektrischen Vielschichtbauelements eine PZT (Blei-Zirkonat-Titanat) -Keramik enthalten. Es hat sich herausgestellt, dass Metalle, insbesondere Kupfer, während des Sinterns des piezoelektrischen Vielschichtbauelements mit verhältnismäßig geringem Widerstand durch eine PZT-Keramik diffundieren können. Somit kann der Diffusionsprozess eines Metalls zwischen zwei Bereichen des piezoelektrischen Vielschichtbauelements, in denen das erste Metall in unterschiedlichen Konzentrationen vorliegt, begünstigt werden.

Es wird außerdem ein Verfahren zur Herstellung eines piezoelektrischen Vielschichtbauelements angegeben, bei dem das zuvor beschriebene Zwischenprodukt gesintert wird, wobei das erste Metall teilweise aus der zweiten Elektrodenschicht in die erste Elektrodenschicht diffundiert und dabei Hohlräume in der zweiten Elektrodenschicht hinterlässt, wodurch die zweite Elektrodenschicht mechanisch geschwächt wird.

Im Betrieb des piezoelektrischen Vielschichtbauelements kann die mechanisch geschwächte zweite Elektrodenschicht als Sollbruchschicht dienen, durch die, z. B. bei bestimmten Zugbelastungen des Vielschichtbauelements, ein kontrollierter Riss parallel zu den piezokeramischen Schichten beziehungsweise zu den Elektrodenschichten verlaufen kann.

Benachbarte piezokeramische Schichten können sich beim Sintern in den Bereichen zwischen den Hohlräumen verbinden.

Die beschriebenen Gegenstände werden anhand der folgenden Ausführungsbeispiele und Figuren näher erläutert. Dabei zeigt:
- Figur 1: einen Längsschnitt eines Piezoaktors,
- Figuren 2a und 2b: Polungsrisse in einem Piezoaktor,
- Figur 3: einen Längsschnitt eines Abschnitts eines Piezoaktors, bei dem eine erste Elektrodenschicht einer zweiten Elektrodenschicht benachbart ist,
- Figur 4: einen Längsschnitt eines Abschnitts eines Piezoaktors mit gegenpoligen ersten Elektrodenschichten,
- Figur 5: einen Längsschnitt eines Abschnitts eines Piezoaktors mit gleichpoligen ersten Elektrodenschichten.

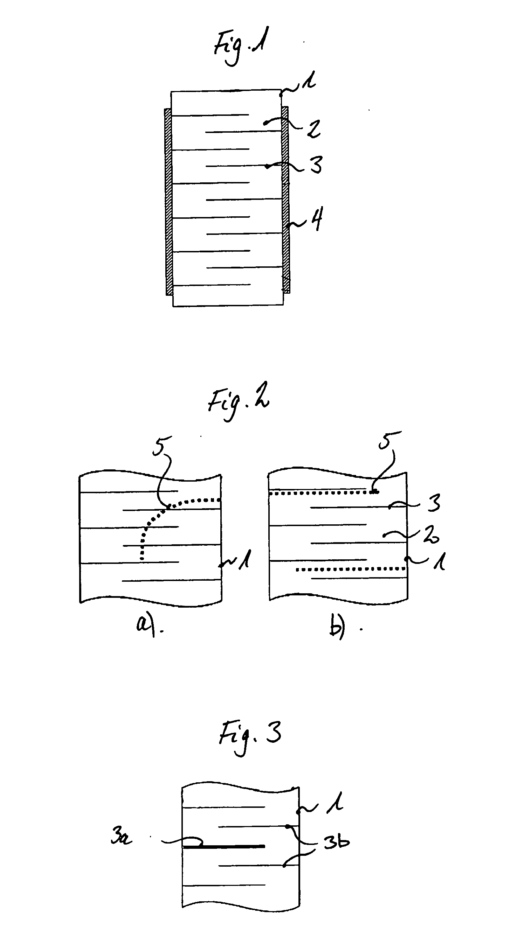

Figur 1 zeigt einen Längsschnitt eines schematisch dargestellten nicht erfindungsgemäßen Piezoaktors, der einen Stapel 1 von piezokeramischen Schichten 2 und dazwischen liegenden Elektrodenschichten 3 aufweist. An zwei Längsseiten des Stapels 1 sind Außenkontakte 4 in Form externer Metallisierungen aufgebracht, die die bis an diese Längsseiten herangeführten Elektrodenschichten 3 elektrisch kontaktieren. Benachbarte Elektrodenschichten unterschiedlicher Polarität überlappen sich in orthogonaler Projektion (welche parallel zur Stapelachse des Piezoaktors verläuft). Im Überlappbereich, der als aktive Zone bezeichnet werden kann, führt ein elektrisches Feld zur Erzeugung einer Auslenkung beziehungsweise Dehnung einer zwischen diesen Elektrodenschichten vorhandenen piezokeramischen Schicht 2. Der Bereich, in denen sich gegenpolige, benachbarte Elektrodenschichten 3 nicht überlappen, wird als inaktive Zone bezeichnet. In diesem Bereich kommt so gut wie keine Auslenkung durch den piezoelektrischen Effekt zustande.

Figur 2a zeigt ein nicht erfindungsgemäßes Ausführungsbeispiel, welches nicht unter die vorliegenden Ansprüche fällt. Figur 2a zeigt, wie ein Riss 5 mehrere Elektrodenschichten 3, insbesondere gegenpolige Elektrodenschichten 3 eines Piezoaktors, verbindet.

Die Erfinder haben festgestellt, dass die Zuverlässigkeit eines Piezoaktors entscheidend von der Beherrschung eventuell auftretender Risse abhängt. Bei thermischen Prozessen wie zum Beispiel beim Sintern bei Temperaturen zwischen 800 und 1500° C, Metallisieren und Löten sowie bei der Polarisation des gesinterten Piezoaktors entstehen aufgrund der unterschiedlichen Dehnung in der aktiven und inaktiven Zone mechanische Spannungen, die zu so genannten Entlastungsrissen und/oder Polungsrissen des Piezoaktors führen. Diese laufen in der inaktiven Zone entlang oder in einer Elektrodenschicht 3. Beim Übergang in den aktiven Bereich können diese Risse abknicken. Wenn diese Risse dabei mindestens zwei Elektrodenschichten überbrücken, können Kurzschlüsse entstehen, welches zum Versagen des Piezoaktors führen wird. Risse, die parallel zu den Innenelektroden verlaufen, stellen dagegen nahezu keine Gefahr für Lebensdauer von Piezoaktoren dar.

Figur 2b zeigt ein nicht erfindungsgemäßes Ausführungsbeispiel, welches nicht unter die vorliegenden Ansprüche fällt. Figur 2b zeigt einen unschädlichen Verlauf eines Risses 5 im Stapel 1 eines Piezoaktors. Dabei verläuft der Riss im Wesentlichen parallel zu einer Elektrodenschicht 3 beziehungsweise zu einer piezokeramischen Schicht 2, sodass der Riss keine gegenpoligen Elektrodenschichten verbindet und damit auch keine Kurzschlüsse verursacht.

Eine Idee zur Vermeidung von schädlichen Rissen gemäß Figur 2a liegt in der Verwendung von benachbarten metallischen Schichten aus verschiedenen Materialien, um Diffusionsprozesse, die aufgrund der unterschiedlichen Zusammensetzungen dieser metallischen Schichten während des Sintervorgangs bei höheren Temperaturen stattfinden sollen, anzuregen. Während des Diffusionsprozesses soll eine metallische Schicht, beziehungsweise eine Komponente einer Legierung dieser Schicht, mehr Material verlieren als die andere. Dabei werden in dieser metallischen Schicht Hohlräume entstehen, welche zur mechanischen Abschwächung dieser Schicht führen werden. Polungs- oder andere Risse würden daher bevorzugt in der mechanisch abgeschwächten metallischen Schicht entstehen und sich nur dort fortpflanzen.

Figur 3 zeigt ein nicht erfindungsgemäßes Ausführungsbeispiel, welches nicht unter die vorliegenden Ansprüche fällt. Figur 3 zeigt einen Abschnitt eines Stapels 1 eines piezoelektrischen Vielschichtbauelements, bei dem zwischen zwei zweiten Elektrodenschichten 3b eine erste Elektrodenschicht 3a auf einer piezokeramischen Schicht 2 aufgebracht ist, wobei die erste Elektrodenschicht 3a eine geringere Konzentration eines ersten Metalls aufweist, als die benachbarten zweiten Elektrodenschichten. Die piezokeramischen Schichten enthalten beispielsweise eine Keramik mit einer Zusammensetzung gemäß den folgenden Formeln:

(PbₓNd_{y}) ((Zr_{1-z}Ti_{z})₁₋ₐNiₐ)O₃,

wobei
0,90 ≤ x ≤ 1,10;
0,0001 ≤ y ≤ 0,06;
0,35 ≤ z ≤ 0,60;
0 ≤ a < 0,10.

Die zweiten Elektrodenschichten 3b enthalten beispielsweise ausschließlich Kupfer. Die ersten Elektrodenschichten 3a enthalten gemäß eines nicht erfindungsgemäßen Ausführungsbeispiels ein Material mit der Zusammensetzung (1-x) Cu / x Pd, wobei 0 < x < 1 ist. Dieses Material kann entweder eine Mischung aus Kupfer- und Palladiumpulver sein oder eine Legierung aus beiden Metallen. Alternativ dazu kann gemäß eines nicht erfindungsgemäßen Ausführungsbeispiels anstelle von Kupfer auch ein anderes Metall, wie z. B. Silber, eingesetzt werden. Die ersten Elektrodenschichten 3a enthalten gemäß eines nicht erfindungsgemäßen Ausführungsbeispiels eine Mischung oder eine Legierung aus Silber und Palladium. Die zweiten Elektrodenschichten 3b enthalten gemäß dieses nicht erfindungsgemäßen Ausführungsbeispiels beispielsweise nur Silber.

Der Unterschied in der Zusammensetzung der ersten Elektrodenschicht 3a und der zweiten Elektrodenschicht 3b wird bei höheren Temperaturen Diffusionsprozesse anregen. Es hat sich gezeigt, dass das Kupfer eine höhere Mobilität in piezoelektrischen Keramiken auf Basis von PZT zeigt als Palladium. Dies führt dazu, dass die Diffusion nur in eine Richtung stattfindet, nämlich aus der zweiten Elektrodenschicht 3b aus reinem Kupfer in die erste Elektrodenschicht 3a enthaltend gemäß des nicht erfindungsgemäßen Ausführungsbeispiels Kupfer und Palladium. Die Kupfer und Palladium enthaltende erste Elektrodenschicht 3a spielt somit die Rolle einer Kupfersenke. Der Materialverlust in der zweiten Elektrodenschicht 3b in direkter Nachbarschaft zur ersten Kupfer-Palladium-Elektrodenschicht 3a führt zur Bildung von Hohlräumen in der zweiten Elektrodenschicht 3b beziehungsweise an der Grenze zwischen der zweiten Elektrodenschicht 3b und einer umliegenden beziehungsweise benachbarten piezokeramischen Schicht 2. Somit werden Bedingungen geschaffen für Bildung und Fortpflanzung von kontrollierten Rissen, die im Wesentlichen parallel zu piezokeramischen Schichten 2 verlaufen.

Der Anteil von Hohlräumen in der zweiten Elektrodenschicht 3b kann durch die Zusammensetzung der ersten Elektrodenschichten, die Dicke der ersten und der zweiten Elektrodenschicht sowie durch Partikelgrößen von Metallteilchen in den Elektrodenschichten gesteuert werden.

Nur eine bestimmte Anzahl von Elektrodenschichten muss dabei eine besondere Materialzusammensetzung aufweisen, um Diffusionsprozesse anzuregen. Das vereinfacht die Herstellung des Piezoaktors.

Die zweiten Elektrodenschichten 3b werden während des Sinterprozesses des Piezoaktors einen bestimmten Anteil ihres Materials verlieren und so mechanisch geschwächt. Vorzugsweise wird dabei der Anteil von Hohlräumen in den abgeschwächten zweiten Elektrodenschichten nicht zu groß, sodass diese zweiten Elektrodenschichten im Betrieb elektrisch aktiv bleiben, d. h. zum Aufbau elektrischer Felder eingesetzt werden können. So wird bevorzugt, dass die Zusammensetzung der beiden Sorten von Elektrodenschichten so eingestellt ist, dass ein Kompromiss erzielt wird zwischen (a) ausreichend viele Hohlräume, um eine genügende Abschwächung der zweiten Elektrodenschichten zu erreichen, (b) nicht zu viele Hohlräume in den zweiten Elektrodenschichten, damit kein Verlust an Performance des Piezoaktors im Betrieb stattfindet. Wird dieser Kompromiss erreicht, führt das zu einem weiteren Vorteil des beschriebenen Piezoaktors: das gesamte Volumen des Piezoaktors kann elektrisch aktiv bleiben.

Die zweiten Elektrodenschichten 3b im Piezoaktor können anstelle von Kupfer auch andere Materialien enthalten, wie zum Beispiel eine Legierung aus Kupfer und einem anderen Metall oder eine Mischung aus Kupferpulver mit einem anderen anorganischen Material, zum Beispiel Metall oder ein Oxid.

Beispielsweise können zweite Elektrodenschichten aus einer Mischung oder Legierung von Kupfer und Nickel bestehen oder auch aus einer Mischung von Kupfer und Nickeloxid bestehen.

Es folgt eine genauere Beschreibung einer bevorzugten Zusammensetzung einer ersten Elektrodenschicht. Diese Zusammensetzung ist nicht erfindungsgemäß und fällt nicht unter die vorliegenden Ansprüche. Kupfer ist zu einem Gewichtsanteil von 99,9 % bis 70 %, besonders bevorzugt zu einem Anteil von 97 % bis 75 %, vorhanden. Der Rest der ersten Elektrodenschicht enthält als Metall Palladium. Dabei wird entweder eine Legierung aus Kupfer und Palladium oder eine Mischung aus Kupferpulver und Palladiumpulver verwendet.

Kupferpartikel in der ersten Elektrodenschicht 3a und/oder in der zweiten Elektrodenschicht 3b weisen Durchmesser von 0,1 bis 10 µm, vorzugsweise 0,4 bis 1,5 µm, auf.

Palladiumpartikel in der ersten Elektrodenschicht weisen ebenfalls Durchmesser von 0,1 bis 10 µm, vorzugsweise 0,4 bis 1,5 µm auf. Andere Metallpartikel, beispielsweise auch Partikel aus Metalllegierungen, können ebenfalls diese Größen aufweisen.

Vorzugsweise werden die ersten Elektrodenschichten 3a und die zweiten Elektrodenschichten 3b mittels Siebdruck, Sputtern oder Sprühen auf piezokeramische Schichten aufgebracht.

Die Dicken beider Sorten von Elektrodenschichten 3a, 3b im nicht gesinterten Zustand des Piezoaktors liegen vorzugsweise zwischen 0,1 und 20 µm, vorzugsweise 1,0 und 10 µm.

Es wird bevorzugt, dass mindestens eine Elektrodenschicht 3a der ersten Sorte im Piezoaktor eingebaut ist. Es können auch alle Elektrodenschichten 3 des Piezoaktors, bis auf eine, als erste Elektrodenschichten 3a und die restliche Elektrodenschicht als zweite Elektrodenschicht 3b ausgeführt sein. Somit wird zumindest eine Sollbruch-Elektrodenschicht beim Sintern erzeugt. Vorzugsweise betragen die ersten Elektrodenschichten 3a jedoch 5 bis 20 % der Gesamtzahl der im Piezoaktor vorhandenen Elektrodenschichten 3.

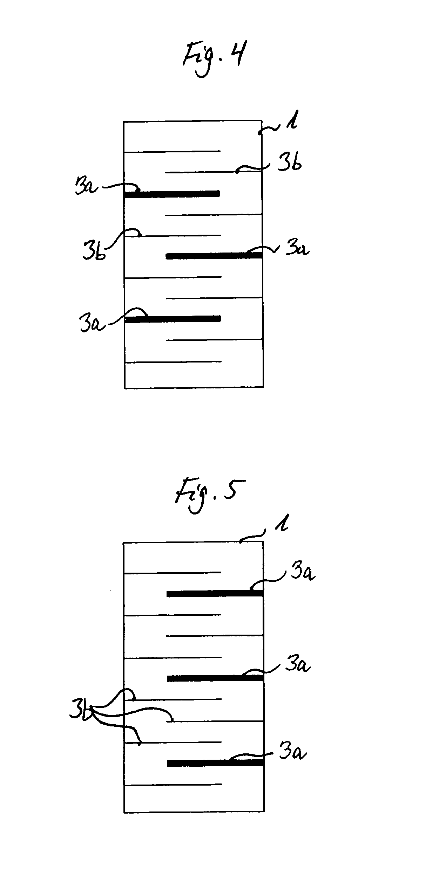

Figur 4 zeigt einen Längsschnitt eines Abschnitts eines Stapels 1 eines Piezoaktors, bei dem erste Elektrodenschichten 3a abwechselnd an verschiedene Längsseiten des Stapels 2 herangeführt sind. Die Polaritäten der ersten Elektrodenschichten 3a wechseln somit entlang der Stapelrichtung ab, da die ersten Elektrodenschichten 3a abwechseln mit zwei verschiedenen Außenkontakten (nicht gezeigt, siehe hierzu jedoch Figur 1) kontaktiert sind.

Figur 5 zeigt einen Längsschnitt eines Abschnitts eines Stapels 1 eines Piezoaktors, bei dem entlang der Stapelrichtung erste Elektrodenschichten 3a immer an dieselbe Längsseite des Stapels herangeführt sind. Die ersten Elektrodenschichten 3a sind somit als gleichpolig zu verstehen, da sie denselben Außenkontakt (nicht gezeigt, siehe hierzu jedoch Figur 1) kontaktieren.

### Bezugszeichenliste

- 1: Stapel aus piezokeramischen Schichten und Elektrodenschichten
- 2: piezokeramische Schicht
- 3: Elektrodenschicht
- 3a: erste Elektrodenschicht
- 3b: zweite Elektrodenschicht
- 4: Außenkontakt
- 5: Riss

## Patentansprüche

1. Piezoelektrisches Vielschichtbauelement als Zwischenprodukt, aufweisend einen Stapel (1) von übereinander angeordneten, grünen piezokeramischen Schichten (2), wobei eine erste Elektrodenschicht (3a) auf einer piezokeramischen Schicht (2) aufgebracht ist und ein erstes Metall enthält, und wobei eine zweite Elektrodenschicht (3b) auf einer weiteren piezokeramischen Schicht aufgebracht ist und der ersten Elektrodenschicht in Stapelrichtung benachbart ist,
wobei die erste Elektrodenschicht (3a) das erste Metall als Hauptkomponente mit einem Gewichtsanteil größer als 50 % enthält,
wobei die zweite Elektrodenschicht (3b) das erste Metall in einer höheren Konzentration enthält als die erste Elektrodenschicht, wobei "Konzentration" den Gewichtsanteil des Metalls in der jeweiligen Elektrodenschicht (3a, 3b) bezeichnet,
und wobei die erste Elektrodenschicht (3a) ein zusätzliches, zweites Metall enthält, das sich vom ersten Metall unterscheidet,
**dadurch gekennzeichnet, dass**
das erste Metall in der ersten Elektrodenschicht (3a) in einer Konzentration von bis zu 80 % vorliegt,
das erste Metall im Wesentlichen aus Kupfer besteht und dass das zweite Metall ausgewählt ist aus: Mangan, Zinn, Wismut, Chrom, Molybdän, Niob, Rubidium.

2. Piezoelektrisches Vielschichtbauelement nach Anspruch 1, bei dem das erste Metall in Partikeln mit Durchmessern zwischen 0,1 und 10 µm vorliegt.

3. Piezoelektrisches Vielschichtbauelement nach einem der vorherigen Ansprüche, bei dem das zweite Metall schlechter durch eine der ersten Elektrodenschicht (3a) benachbarte piezokeramische Schicht (2) diffundieren kann als das erste Metall.

4. Piezoelektrisches Vielschichtbauelement nach einem der vorhergehenden Ansprüche, bei dem die zweite Elektrodenschicht (3b) als Metall ausschließlich das erste Metall enthält.

5. . Piezoelektrisches Vielschichtbauelement nach einem der vorhergehenden Ansprüche, bei dem der Konzentrationsunterschied des ersten Metalls zwischen der ersten Elektrodenschicht (3a) und der zweiten Elektrodenschicht (3b) derart eingestellt ist, dass bei Erwärmung des Vielschichtbauelements eine Diffusion des ersten Metalls aus der zweiten Elektrodenschicht (3b) zu einem Materialverlust der zweiten Elektrodenschicht (3b) führt, wobei die zweite Elektrodenschicht (3b) strukturell intakt bleibt, um im Betrieb des Vielschichtbauelements als Elektrodenschicht wirken zu können.

6. . Piezoelektrisches Vielschichtbauelement nach einem der vorhergehenden Ansprüche, bei dem die piezokeramischen Schichten (2) eine PZT-Keramik enthalten.

7. . Verfahren zur Herstellung eines piezoelektrischen Vielschichtbauelements, bei dem ein als Zwischenprodukt hergestelltes piezoelektrisches Vielschichtbauelement nach einem der vorhergehenden Ansprüche gesintert wird, wobei das erste Metall teilweise aus der zweiten Elektrodenschicht (3b) in die erste Elektrodenschicht (3a) diffundiert und dabei Hohlräume (7) in der zweiten Elektrodenschicht (3b) hinterlässt, wodurch die zweite Elektrodenschicht mechanisch geschwächt wird.

8. Verfahren nach Anspruch 7, bei dem sich benachbarte piezokeramische Schichten (2) beim Sintern zwischen den Hohlräumen (7) verbinden.

9. . Piezoelektrisches Vielschichtbauelement, das unmittelbar nach einem Verfahren der vorhergehenden Ansprüche erzeugbar ist.

## Claims

1. Piezoelectric multilayer component as an intermediate product, having a stack (1) of green piezoceramic layers (2) which are arranged one on top of the other, wherein a first electrode layer (3a) is applied to a piezoceramic layer (2) and contains a first metal, and wherein a second electrode layer (3b) is applied to a further piezoceramic layer, adjacent to the first electrode layer in the stacking direction, wherein the first electrode layer (3a) contains the first metal as a main component with a proportion by weight of greater than 50%, wherein the second electrode layer (3b) contains the first metal in a higher concentration than the first electrode layer, wherein "concentration" designates the proportion by weight of the metal in the respective electrode layer (3a, 3b), and wherein the first electrode layer (3a) contains an additional, second metal, which is not the same as the first metal, **characterized in that** the first metal is in a concentration of up to 80% in the first electrode layer (3), the first metal essentially consists of copper and the second metal is selected from: manganese, tin, bismuth, chromium, molybdenum, niobium, rubidium.

2. Piezoelectric multilayer component according to Claim 1, in which the first metal is present in particles having diameters between 0.1 and 10 µm.

3. Piezoelectric multilayer component according to one of the preceding claims,
in which the second metal cannot diffuse as well as the first metal through a piezoceramic layer (2) which is adjacent to the first electrode layer (3a).

4. Piezoelectric multilayer component according to one of the preceding claims,
in which the second electrode layer (3b) contains exclusively the first metal as metal.

5. Piezoelectric multilayer component according to one of the preceding claims,
in which the concentration difference of the first metal between the first electrode layer (3a) and the second electrode layer (3b) is set such that, when the multilayer component is heated, diffusion of the first metal from the second electrode layer (3b) leads to material being lost from the second electrode layer (3b), wherein the second electrode layer (3b) remains structurally intact, in order to allow it to act as an electrode layer during operation of the multilayer component.

6. Piezoelectric multilayer component according to one of the preceding claims, in which the
piezoceramic layers (2) contain a PZT ceramic.

7. Method for producing a piezoelectric multilayer component in which a piezoelectric multilayer component according to one of the preceding claims, produced as an intermediate product, is sintered, wherein the first metal diffuses partially from the second electrode layer (3b) into the first electrode layer (3a) and in the process leaves cavities (7) in the second electrode layer (3b), thus mechanically weakening the second electrode layer.

8. Method according to Claim 7,
in which adjacent piezoceramic layers (2) are connected between the cavities (7) during sintering.

9. Piezoelectric multilayer component which can be produced directly using a method according to the preceding claims.

## Revendications

1. Composant multicouche piézoélectrique en tant que produit intermédiaire, présentant un empilement (1) de couches céramiques piézoélectriques crues (2), disposées l'une au-dessus de l'autre, dans lequel une première couche d'électrode (3a) est déposée sur une couche céramique piézoélectrique (2) et contient un premier métal, et dans lequel une deuxième couche d'électrode (3b) est déposée sur une autre couche céramique piézoélectrique et est voisine de la première couche d'électrode dans la direction d'empilement, dans lequel la première couche d'électrode (3a) contient le premier métal comme composant principal avec une proportion en poids supérieure à 50 %,
dans lequel la deuxième couche d'électrode (3b) contient le premier métal en une concentration plus élevée que la première couche d'électrode, dans lequel le terme 'concentration' désigne la proportion en poids du métal dans la couche d'électrode respective (3a, 3b),
et dans lequel la première couche d'électrode (3a) contient un deuxième métal supplémentaire, qui est différent du premier métal,
**caractérisé en ce que** le premier métal se trouve dans la première couche d'électrode (3a) en une concentration pouvant aller jusque 80 %, le premier métal se compose essentiellement de cuivre, et **en ce que** le deuxième métal est choisi parmi le manganèse, l'étain, le bismuth, le chrome, le molybdène, le niobium, le rubidium.

2. Composant multicouche piézoélectrique selon la revendication 1, dans lequel le premier métal est présent sous forme de particules de diamètres compris entre 0,1 et 10 µm.

3. Composant multicouche piézoélectrique selon l'une quelconque des revendications précédentes, dans lequel le deuxième métal peut diffuser plus mal que le premier métal à travers une couche céramique piézoélectrique (2) voisine de la première couche d'électrode (3a).

4. Composant multicouche piézoélectrique selon l'une quelconque des revendications précédentes, dans lequel la deuxième couche d'électrode (3b) contient comme métal exclusivement le premier métal.

5. Composant multicouche piézoélectrique selon l'une quelconque des revendications précédentes, dans lequel la différence de concentration du premier métal entre la première couche d'électrode (3a) et la deuxième couche d'électrode (3b) est réglée de telle manière que, lors d'un chauffage du composant multicouche, une diffusion du premier métal hors de la deuxième couche d'électrode (3b) conduise à une perte de matière de la deuxième couche d'électrode (3b), dans lequel la deuxième couche d'électrode (3b) reste structurellement intacte, afin de pouvoir agir comme couche d'électrode pendant le fonctionnement du composant multicouche.

6. Composant multicouche piézoélectrique selon l'une quelconque des revendications précédentes, dans lequel les couches céramiques piézoélectriques (2) contiennent une céramique PZT.

7. Procédé de fabrication d'un composant multicouche piézoélectrique, dans lequel on fritte un composant multicouche piézoélectrique fabriqué en tant que produit intermédiaire selon l'une quelconque des revendications précédentes, dans lequel le premier métal diffuse partiellement hors de la deuxième couche d'électrode (3b) dans la première couche d'électrode (3a) et laisse en l'occurrence des cavités (7) dans la deuxième couche d'électrode (3b), affaiblissant ainsi mécaniquement la deuxième couche d'électrode (3b).

8. Procédé selon la revendication 7, dans lequel des couches céramiques piézoélectriques (2) voisines l'une de l'autre s'assemblent entre les cavités (7) pendant le frittage.

9. Composant multicouche piézoélectrique, qui peut être produit directement selon un procédé des revendications précédentes.
